# EUROPEAN PATENT SPECIFICATION

(11) **EP 0 777 234 B1**
(45) Date of publication and mention of the grant of the patent: **05.03.2003**
(21) Application number: 96118946.1
(22) Date of filing: 27.11.1996
(51) Int. Cl.: G11C 11/409, G11C 7/06

(54) **Sense amplifier in or relating to semiconductor memory devices**
Leseverstärker für oder in Beziehung auf Halbleiterspeicheranordnungen
Amplificateur de détection pour ou relatif à des dispositifs de mémoire à semi-conducteurs

(30) Priority: 29.11.1995 US 7675
(43) Date of publication of application: 04.06.1997
(73) Proprietor: TEXAS INSTRUMENTS INCORPORATED, Dallas, Texas 75243 (US)
(72) Inventor: Haukness, Brent S., Garland, TX 75044 (US); McAdams, Hugh, McKinney, TX 75070 (US)
(74) Representative: Holt, Michael

(56) References cited:
- US-A- 4 984 202
- US-A- 5 341 331
- US-A- 5 359 561

## Description

### BACKGROUND OF THE INVENTION

### FIELD OF THE INVENTION

This invention relates generally to semiconductor devices and, more particularly, to dynamic random access memory (DRAM) units. A dynamic random access memory unit includes a sense amplifier which detects the logic state of a memory unit storage element.

### DESCRIPTION OF THE RELATED ART

The sense amplifier units associated with the storage capacitors of the DRAM units sense or detect the state of the charge on the capacitor and apply an output sense signal dependent on that charge state. Direct sensing has been proposed for future generations of DRAM units because of advantages in speed and because the timing of such units is less critical. A typical direct sensing configuration requires an additional six transistors between the Y-select transistors of the sense amplifier and the input/output (I/O) lines of DRAM unit. For performance reasons, these transistors should be located as close to the sense amplifier as possible. In the ideal situation, this amplifier should be a part of the sense amplifier itself. The location of these transistors in the sense amplifier itself results in an increase in the layout area required by the sense amplifier circuit.

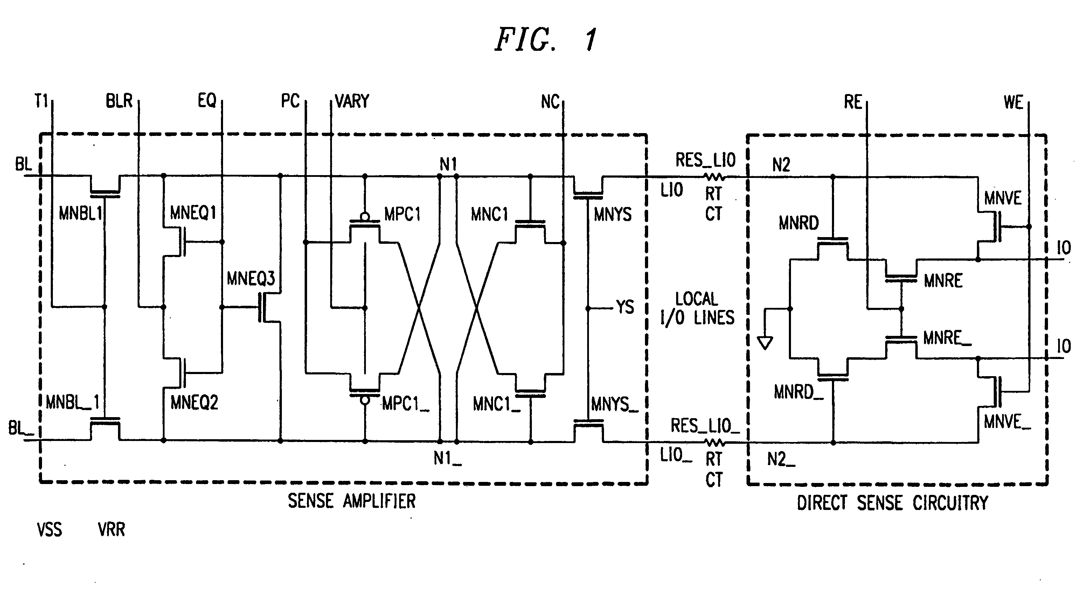

Referring to Fig. 1, a direct sense configuration for detecting the stored charge on the storage capacitor, according to the prior art, is shown. A BL signal is applied to a first source-drain terminal of n-channel field effect transistor MNBL1, while a BL_ signal is applied to a first source-drain terminal of n-channel field effect transistor MNBL1_. A T1 signal is applied to a gate terminal of transistor MNBL1 and to a gate terminal of transistor MNBL1_. A second source-drain terminal of transistor MNBL1 is coupled to a first source-drain terminal of n-channel field effect transistor MNEQ1, to a first source-drain terminal of n-channel field effect transistor MNEQ3, to a first gate terminal of p-channel field effect transistor MPC1, to a first source-drain terminal of p-channel field effect transistor MPC1_, to a first source-drain terminal of n-channel field effect transistor MNC1_, to a gate terminal of n-channel field effect transistor MNC1, and to a first source-drain terminal of n-channel field effect transistor MNYS. A second source-drain terminal of transistor MNB1_ is coupled to a first source-drain terminal of n-channel field effect transistor MNEQ2, to a second source-drain terminal of n-channel field effect transistor MNEQ3, to a gate terminal of transistor MPC1_, to a first source-drain terminal of transistor MPC1, to a first source-drain terminal of transistor MNC1, to a gate terminal of transistor MNC1_, and to a first source-drain terminal of n-channel field effect transistor MNYS_. A BLR signal is coupled to a second source-drain terminal of transistor MNEQ1 and to a second source-drain terminal of transistor MNEQ2. An EQ signal is applied to a gate terminal of transistor MNEQ1, to a gate terminal of transistor MNEQ2, and to a gate terminal of transistor MNEQ3. A PC signal is applied to a second source-drain terminal of transistor MPC1 and to a second source-drain terminal of transistor MPC1_. A VARY potential is applied to the substrates of transistors MPC1 and MPC1_. An NC signal is applied to a second source-drain terminal of MNC1 and a second source-drain terminal of MNC1_. A YS (Y-SELECT) signal is applied to a gate terminal of transistor MNYS and to a gate terminal of transistor MNYS_. A second source-drain terminal of transistor MNYS is coupled to a first terminal of a first local input/output line RES_LIO, while a second signal terminal of transistor MNYS_ is coupled to a first terminal of a second local I/O line RES_LIO_. A second terminal of local I/O line RES_LIO is coupled to a gate terminal of n-channel field effect transistor MNRD and to a first source-drain terminal of n-channel field effect transistor MNWE. A second terminal of local I/O line RES_LIO_ is coupled to a gate terminal of n-channel field effect transistor WNRD_ and to a first source-drain terminal of n-channel field effect transistor MNWE_. A first source-drain terminal of transistor MNRD and a first source-drain terminal of transistor MNRD_ are coupled to ground potential. A second source-drain terminal of transistor MNRD is coupled to a first source-drain terminal of n-channel field effect transistor MNRE, while a second source-drain terminal of transistor MNRD_ is coupled to a first source-drain terminal of n-channel field effect transistor MNRE_. A RE (READ-ENABLE) signal is applied to gate terminals of transistors MNRE and MNRE_. A WE (WRITE_ENABLE) signal is applied to gate terminals of transistors MNWE and MNWE_. A second source-drain terminal of transistor MNWE and a second source-drain terminal of transistor MNRE are coupled to a first I/O terminal. A second source-drain terminal of transistor MNWE_ and a second source-drain terminal of transistor MNRE_ are coupled to a second I/O terminal.

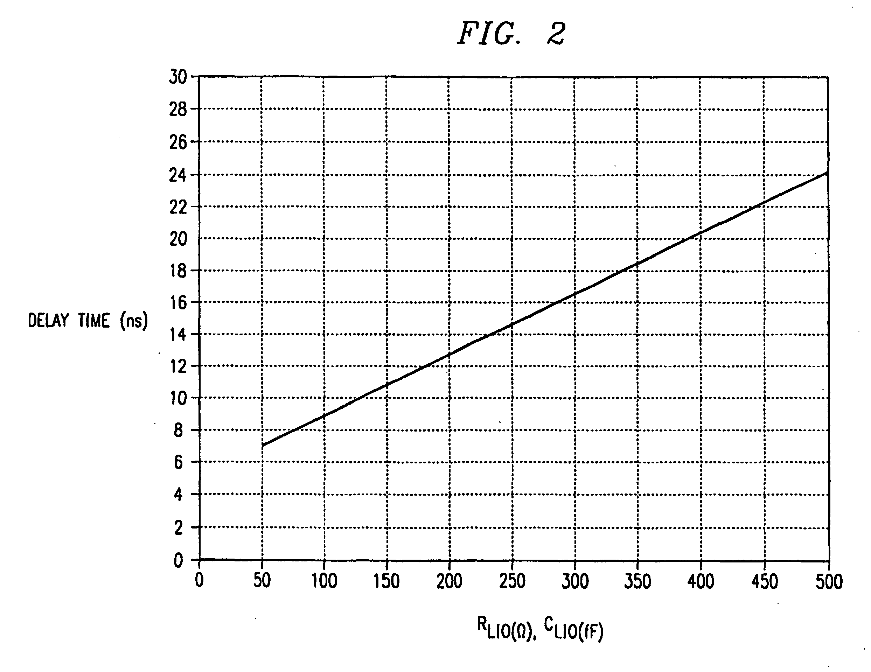

Referring to Fig. 2, a time delay for a read-write operation as a function of parasitic impedances for the circuit shown in Fig.1 is shown. Removing or minimizing this delay is one of the objects of the present invention.

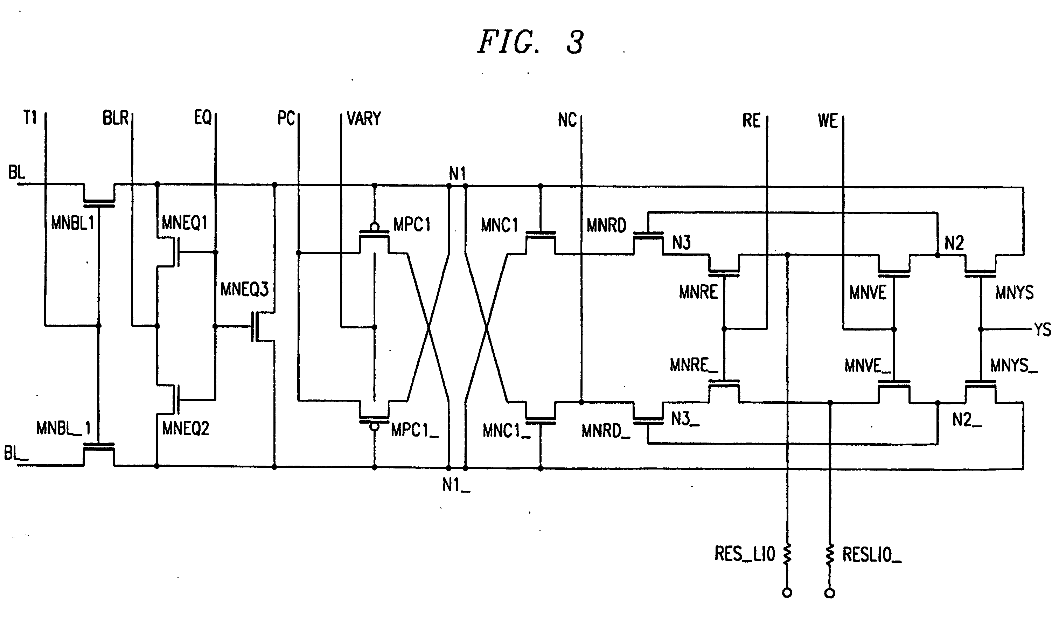

Referring to Fig. 3, a sense amplifier, including a conventional direct sense circuitry, is shown. A BL signal is coupled to a first source-drain terminal of n-channel field effect transistor MNBL, while a BL_ signal is applied to a first source-drain of n-channel field effect transistor MNBL_.

A T1 signal is applied to a gate terminal of transistor MNBL and to a gate terminal of transistor MNBL_. A second signal terminal of transistor MNBL is coupled to a first source-drain terminal of n-channel field effect transistor MNEQ1, to a first source-drain terminal of n-channel field effect transistor MNEQ3, to a gate terminal of p-channel field effect transistor MPC1, to a first source-drain terminal of n-channel field effect transistor MPC1_, to a first source-drain terminal of n-channel field effect transistor MNC1_, to a gate terminal of n-channel field effect transistor MNC1, and to a first source-drain terminal of n-channel field effect transistor MNYS. A second source-drain terminal of transistor MNBL_ is coupled to a first source-drain terminal of n-channel field effect transistor MNEQ2, to a second source-drain terminal of transistor MNEQ3, to a gate terminal of transistor MPC1_, to a first source-drain terminal of transistor MPC1, to a first source-drain terminal of transistor MNC1, to a gate terminal of transistor MNC1_, and to a first source-drain terminal of n-channel field effect transistor MNYS_. A BLR signal is applied to a second source-drain terminal of transistor MNEQ1 and to a second source-drain terminal of transistor MNEQ2. An EQ signal is applied to a gate terminal of transistor MNEQ1, to a gate terminal of transistor MNEQ2, and to a gate terminal of transistor MNEQ3. A PC signal is applied to a second source-drain terminal of transistor MPC1_ and to a second source-drain terminal of transistor MPC1_. A VARY potential is applied to the substrates of transistor MPC1 and transistor MNPC2_. An NC signal ia coupled to a second source-drain terminal of transistor MNC1, to a first source-drain terminal of n-channel field effect transistor MNRD, to a second source-drain terminal of transistor MNC1_, and to a first source-drain terminal of n-channel field effect transistor MNRD_. A gate terminal of transistor MNRD is coupled to a second source-drain terminal of transistor MNYS and to a second source-drain terminal of n-channel field effect transistor MNWE, while a gate terminal of transistor MNRD_ is coupled to a second source-drain terminal of transistor MNYS_ and to a first source-drain terminal of n-channel field effect transistor MNWE_. A second source-drain terminal of transistor MNRD is coupled to a first source-drain terminal of n-channel field effect transistor MNRE. A second source-drain terminal of transistor MNRD_ is coupled to a first signal terminal of n-channel field effect transistor MNRE_. A second source-drain terminal of transistor MNRE is coupled to a second source-drain terminal of transistor MNWE and to the local input/output line RES_LIO, while a second terminal of transistor MNRE_ is coupled to a second source-drain terminal of transistor MNWE_ and to a local output line RES_LIO_. An RE signal is coupled to the gate terminal of transistor MNRE and to the gate terminal of transistor MNRE_. A WE signal is coupled to a gate terminal of transistor MNWE and to a gate terminal of transistor MNWE_.

In the direct sensing implementation shown in Fig. 1, the output signals from the sense amplifier are coupled to the gates of read transistors MNRD/MNRD_ through the local I/O lines. In the read operation, the RE (READ-ENABLE) signal is high and the WE (WRITE-ENABLE) signal is low, thereby connecting the read transistors to the I/O lines through the MNRE/MNRE_ transistor pair. Similarly, in a write operation, the WE signal is high and the RE signal is low, thereby connecting the I/O lines directly to the local I/O lines through the MNWE/MNWE_ transistor pair and therefore to the selected sense amplifier through the MNYS/MNYS_ transistor pair. Using this implementation, a plurality of sense amplifiers can be connected to one set of direct-sense transistors as long as only one YS (Y-SELECT) signal is high for sense amplifiers. A principal disadvantage of this approach is that the output data delay is highly dependent on the parasitic impedances of the local I/O lines (RES_LIO/RES_LIO_) as shown in Fig. 2. It is desirable to provide local I/O lines that are as short as possible.

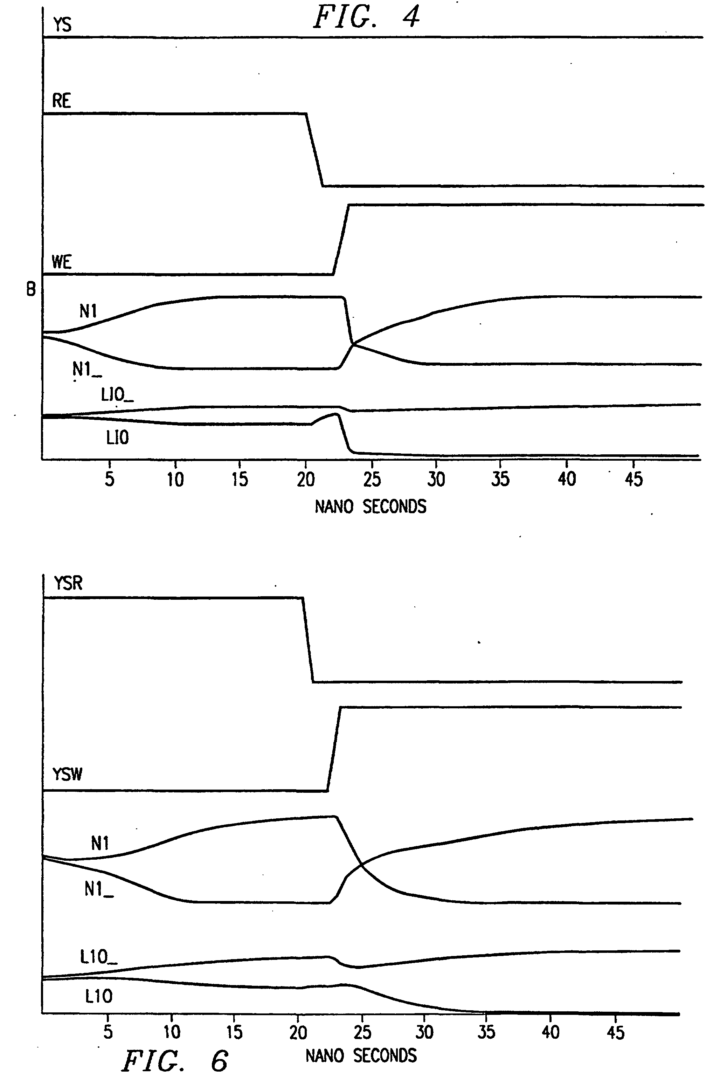

Referring to Fig. 3, the sensing delay associated with the parasitic impedances is minimized by placing the direct-sense circuitry within the sense amplifier itself. The direct-sense circuitry has six related transistors, MNRD/MNRD_, MNRE/MNRE_, and MNWE/MNWE_ in addition to the typical sense amplifier configuration. The RE (READ-ENABLE) and WE (WRITE-ENABLE) signals are global to the entire sense amplifier bank, while the YS (Y-SELECT) signal is high only for the accessed sense amplifier. In the read operation, the RE signal is high, the WE signal is low, and the YS signal is for the selected sense amplifier. This combination of signals causes the nodes N1 and N2, associated with the second terminals of the MNBL/MNBL_ transistor, pair to be coupled to the gate terminals of the MNRD/MNRD_ read transistor pair through the MNYS/MNYS_ transistor pair. The MNRD/MNRD_ read transistor pair are coupled to the local I/Os (RES_LIO/RES_LIO_) through the MNRE/MNRE_ transistor pair as a result of the high RE signal. In a write operation, the RE signal is low, the WE signal is high, and the YS signal is once again high for the selected sense amplifier. This combination of signals couples the RES_LIO/RES_LIO_ the sense nodes N1 and N2 (i.e. second terminals of the MNBL/MNBL_ transistor pair) through the MNWE/MNWE_ transistor pair and the MNYS/MNYS_ transistor pair, thereby bypassing the MNRD/MNRD_ transistor pair. The wave forms of Fig. 4 illustrate this operation for a read-write cycle. The parasitic impedances between the sense nodes and the direct-sense transistors are minimized with this approach. However, the layout area (i.e., of the sense amplifier is greatly increased.

A need has therefore been felt for a sense amplifier including direct-sense circuitry which requires a reduced layout area. In the present invention, the reduced layout area is achieved by reducing the number transistors in the direct-sense circuitry implementation. In US Patent 4,984,202 there is described a memory sense amplifier arrangement containing features as set out in the preamble of Claim 1.

### SUMMARY OF THE INVENTION

The aforementioned and other features are accomplished, according to the present invention, by combining, in a sense amplifier having direct-sense circuitry included therein, the WRITE-ENABLE (WE) and the READ-ENABLE (RE) signals (control information) with the Y-SELECT (YS) signal (address information) to provide a Y-SELECT-WRITE (YSW) signal and a Y-SELECT-READ (YSR) signal. In the prior art, the WRITE-ENABLE signal, the READ-ENABLE signal, and the Y-SELECT signal, along with each signal complement, each control a transistor pair in coupling the selected sense amplifiers to the local I/O lines. In the present invention, the Y-SELECT-WRITE and the Y-SELECT-READ signals, along with each signal complement, also each control a transistor pair in coupling the selected sense amplifier to the local I/O lines. This configuration permits the sense amplifier to be implemented with two fewer transistors, thereby reducing the required layout area.
These and other features of the present invention will be understood upon the reading of the Specification in conjunction with the Figures.

### BRIEF DESCRIPTION OF THE DRAWINGS

The present invention will now be further described, by way of example, with reference to the accompanying drawings in which:
Figure 1 is a schematic circuit diagram of a sense amplifier with an associated direct sense circuitry separated by the local I/O lines according to the prior art;
Figure 2 is a graph of the simulated operational delay time as a function of the parasitic impedance for the sense amplifier of Fig. 1;
Figure 3 is a schematic circuit diagram of a sense amplifier which includes the associated direct sense circuitry according to the prior art;
Figure 4 is a series of graphs showing the simulated time dependence of selected signals for the sense amplifier unit of Fig. 3;
Figure 5 is a schematic circuit diagram of a sense amplifier which includes the associated direct sense circuitry according to the present invention; and
Figure 6 is a series of graphs showing the simulated time dependence of selected signals for the sense amplifier of Fig. 5.

### DETAILED DESCRIPTION OF THE DRAWINGS

Fig. 1, Fig. 2, Fig. 3, and Fig. 4 have been described with respect to the prior art.

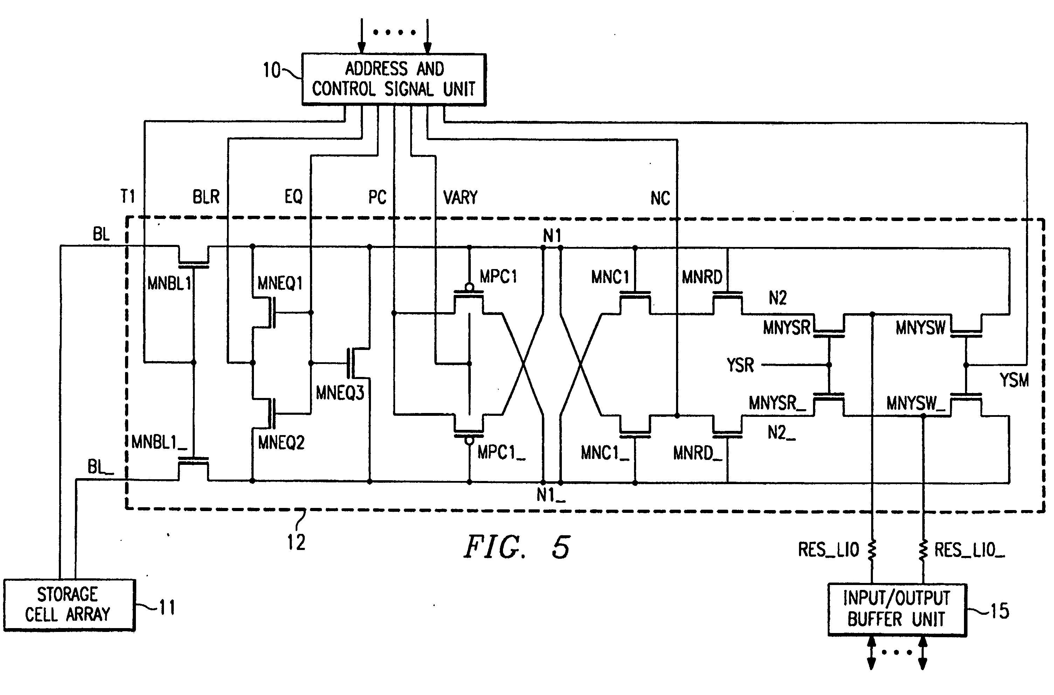

Referring now to Fig. 5, a sense amplifier with direct sense circuitry, according to the present invention, as well as the portions of the dynamic read only memory coupled thereto, is shown. A BL signal is applied to a first source-drain terminal of n-channel field effect transistor MNBL1, while a BL_ signal is applied to a first source-drain terminal of n-channel field effect transistor MNBL_. A T1 signal is applied to a gate terminal of transistor MNBL1 and to a gate terminal of transistor MNBL1_. A second source-drain terminal of transistor MNBL1 (node N1) is coupled to a first source-drain terminal of n-channel field effect transistor MNEQ1, to a first source-drain terminal of n-channel field effect transistor MNEQ3, to a gate terminal of p-channel field effect transistor MPC1, to a first source-drain terminal of p-channel field effect transistor MPC1_, to a first source-drain terminal of n-channel field effect transistor MNC1_, to a gate terminal of n-channel field effect transistor MNC1, to a gate terminal of n-channel field effect transistor MNRD, and to a first source-drain terminal of n-channel field effect transistor MNYSW. A second source-drain terminal of transistor MNBL1_ (node N1_) is coupled to first source-drain terminal of n-channel field effect transistor MNEQ2, to a second source-drain terminal of transistor MNEQ3, to a gate terminal of transistor MPC1_, to a first source-drain terminal of transistor MPC1, to a first source-drain terminal of transistor MNC1, to a gate terminal of transistor MNC1_, to a gate terminal of n-channel field effect transistor MNRD_, and to a first source-drain terminal of n-channel field effect transistor MNYSW_. A BLR signal is applied to a second source-drain terminal of transistor MNEQ1 and to a second source-drain terminal of transistor MNEQ2. An EQ signal is applied to a gate terminal of transistor MNEQ1, to a gate terminal of transistor MNEQ2, and to a gate terminal of transistor MNEQ3. A PC signal is applied to a second source-drain terminal of transistor MPC1 and to a second source-drain terminal of transistor MPC1_. A VARY potential is applied to the substrates of transistor MPC1 and transistor MPC1_. An NC signal is applied to a second source-drain terminal of transistor MNC1, a first source-drain terminal of transistor MNRD, a second source-drain terminal of transistor MNC1_, and to a first source-drain terminal of transistor MNRD_. A second source-drain terminal of transistor MNRD is coupled to a first source-drain terminal of n-channel field effect transistor MNYSR, while a second source-drain terminal of transistor MNRD_ is coupled to a first source-drain terminal of n-channel field effect transistor MNYSR_. A YSW signal is applied to a gate terminal of transistor MNYSW and to a gate terminal transistor MNYSW_. A YSR signal is applied to a gate terminal of transistor MNYSR and a gate terminal of transistor MNYSR_. A second source-drain terminal of transistor MNYSR and a second source-drain terminal of MNYSW are coupled to a first local input/output line RES_LIO. A second source-drain terminal of transistor MNYSW_ and a second source-drain terminal of transistor MNYSR_ are coupled to a second input/output line RES_LIO_. The sense amplifier 12 exchanges data signals with the storage cell array 11, with the direct sense circuit 11 via nodes N1 and N1_, and receives control and address signals from the address and control unit 10. The sense amplifier 12 also exchanges signals with the I/O buffer unit.

Referring to Fig. 6, the simulated time dependence of the sense amplifier of the present invention is shown in relation to the activation signals.

### OPERATION OF THE PREFERRED EMBODIMENT(S)

Referring once again to Fig. 5, the sense amplifier with the direct sense circuitry of the present invention is shown. In addition to the sense amplifier, only four additional transistors, MNYSR/MNYSR_ and MNRD/MNRD_, are required. The MNYSW/MNSYW_ are equivalent to the typical Y-select transistors MNYS/MNYS_ shown in Fig. 1. The reduction in the number of transistors is obtained by using separate, decoded Y-select signals, a YSR (Y-SELECT READ) signal and a YSW (Y-SELECT WRITE) signal, for the read and write operations respectively. The global READ-ENABLE signal and the global WRITE-ENABLE signals, used in the conventional implementations, are not required in the present configuration.

The gates of the read transistor pair MNRD/MNDR_ are always coupled to the sense nodes. In a read operation, all the YSW signals in the sense amplifier bank are low. The YSR signal is high for the selected sense amplifier, thereby coupling the MNRD/MNRD_ transistor pair to the local I/O lines through the MNYSR/MNYSR_ transistor pair. Similarly, in the write operation, all of the YSR signals are low in the sense amplifier bank and only the YSW signal for the selected sense amplifier is high. The high YSW signal provides a direct coupling of the local I/O lines to the sense nodes N1/N1_ through the transistor pair MNYSW/MNYSW_.

Referring to Fig. 6, a comparison between Fig. 6 and Fig. 4 illustrates that the present implementation of the direct-sensing circuitry with the sense amplifier retains the feature of minimizing the effect of local I/O parasitic impedances. Moreover, the present configuration is implemented with a reduced number of transistors, thereby reducing the layout area required for the sense amplifier.

While the invention has been described with particular reference to the preferred embodiment, it will be understood by those skilled in the art that various changes may be made and equivalents substituted for elements of the preferred embodiment without departing from the invention. In addition, many modifications may be made to adapt a particular situation and material to a teaching of the present invention without departing from the essential teachings of the present invention.

As is evident from the foregoing discussion, certain aspects of the invention are not limited to the particular details of the examples illustrated, and it is therefore contemplated that other modifications and applications will occur to those skilled in the art.

## Claims

1. A sense amplifier (12) for use in a memory unit, said sense amplifier comprising:
a local input/output line pair (RES_LIO, RES_LIO_);
a direct sense circuit for coupling said sense amplifier and said local input/output line pair, said direct sense circuit including; a first transistor pair (MNYSW, MNYSW_) responsive to a first signal and
a second transistor pair (MNYSR, MNYSR_) responsive to a second signal, said first signal causing transmission of a data signal from said local input/output line pair to said sense amplifier, said second signal causing transmission of a data signal from said sense amplifier to said local input/output line pair **characterized in that** said first and second signals (YSW,YSR) contain address and control information.

2. The sense amplifier of Claim 1, wherein said memory unit is a dynamic random access memory (DRAM) unit.

3. The sense amplifier of Claim 1 or Claim 2, wherein said first signal is a combination of a WRITE-ENABLE signal and a Y-SELECT signal and said second signal is combination of a READ-ENABLE signal and said Y-SELECT signal.

4. The sense amplifier of any preceding claim, wherein said first signal is applied to a first transistor and a second transistor of said first transistor pair.

5. A method for coupling a sense amplifier (12) and a pair of local input/output lines (RES_LIO,RES_LIO_) in a dynamic random access memory unit, the method comprising the steps of:
applying a first signal to a first transistor pair (MNYSW,MNYSW) coupling said sense amplifier and said local input/output lines, said first transistor pair transferring a data signal from said local input/output lines to said sense amplifier in response to said first signal; and
applying a second signal to a second transistor pair (MNYSR,MNYSR_) coupling said sense amplifier and said local input/output lines, said second signal causing a data signal to be transferred from said sense amplifier to said local input/output lines wherein said step of applying a first signal (YSW) includes applying a signal containing control and address information and said step of applying a second signal (YSR) includes applying a signal containing control and address information.

6. The method of Claim 5, wherein said step of applying a first signal includes the step of combining a WRITE-ENABLE signal and a Y-SELECT signal to form said first signal; and
wherein said step of applying a second signal includes the step of combining a READ-ENABLE signal and a Y-SELECT signal to form said second signal.

7. A memory unit comprising:
a storage cell array for storing data signals;
a sense amplifier (12) for applying data signals to and receiving data signals from said storage cell array;
an address and control unit (10) for applying control signals to said sense amplifier;
an input/output buffer unit (15); local input/output lines (RES_LIO,RES_LIO_) for transmitting signals to and from said input/output buffer unit; and
a direct sense circuit coupled between said input/output buffer unit and said sense amplifier, said direct sense circuit transmitting a data signal from said input/output unit to said sense amplifier in response to a control signal from said address and control signal unit, said direct sense circuit transmitting a data signal from said sense amplifier to said local input/output lines in response to a second control signal from said address and control unit **characterized in that** said first and second signals (YSW,YSR) contain address and control information.

8. The memory unit of Claim 7, wherein said first control signal is a combination of a write-enable signal and a Y-select signal.

9. The memory unit of Claim 7 or Claim 8, wherein said second control signal is a combination of a read-enable signal and said Y-select signal.

10. The memory unit of any of Claims 7 to 9, wherein said first and second signal each include a complement signal.

11. The memory unit of any of Claim 7 to 10, wherein said direct sense circuit includes:
a first transistor pair responsive to said first signal for transmitting a data signal; and
a second transistor pair responsive to said second signal for transmitting a data signal.

12. The memory unit of any of Claims 7 to 11, wherein said memory unit is a dynamic random access memory (DRAM) unit.

## Patentansprüche

1. Leseverstärker (12) zur Verwendung in einer Speichereinheit, welcher aufweist:
ein lokales Ein-/Ausgabeleitungspaar (RES_LIO, RES_LIO_),
eine Direktleseschaltung zum Koppeln des Leseverstärkers und des lokalen Ein-/Ausgabeleitungspaars, wobei die Direktleseschaltung aufweist.
ein erstes Transistorpaar (MNYSW, MNYSW_), das auf ein erstes Signal anspricht, und
ein zweites Transistorpaar (MNYSR, MNYSR_), das auf ein zweites Signal anspricht, wobei das erste Signal die Übertragung eines Datensignals vom lokalen Ein-/Ausgabeleitungspaar zum Leseverstärker bewirkt und wobei das zweite Signal die Übertragung eines Datensignals vom Leseverstärker zum lokalen Ein/Ausgabeleitungspaar bewirkt, **dadurch gekennzeichnet, daß** das eiste und das zweite Signal (YSW, YSR) Adressen- und Steuerinförmationen enthalten.

2. Leseverstärker nach Anspruch 1, wobei die Speichereinheit eine dynamische Direktzugriffsspeichereinheit (DRAM-Einheit) ist.

3. Leseverstärker nach Anspruch 1 oder 2, wobei das erste Signal eine Kombination eines Schreibfreigabesignals und eines Y-Wählsignals ist und das zweite Signal eine Kombination eines Lesefreigabesignals und des Y-Wählsignals ist.

4. Leseverstärker nach einem der vorhergehenden Ansprüche, wobei das erste Signal an einen ersten Transistor und einen zweiten Transistor des ersten Transistorpaars angelegt ist

5. Verfahren zum Koppeln eines Leseverstärkers (12) und eines Paars lokaler Ein-/Ausgabeleitungen (RES_LIO, RES_LIO_) in einer dynamischen Direhtzugriffsspeichereinheit mit den Schritten:
Anlegen eines ersten Signals an ein erstes Transistorpaar (MNYSW, MNYSW), wodurch der Leseverstärker und die lokalen Ein-/Ausgabeleitungen gekoppelt werden, wobei das erste Transistorpaar ansprechend auf das erste Signal ein Datensignal von den lokalen Ein-/Ausgabeleitungen zum Leseverstarker überträgt, und
Anlegen eines zweiten Signals an ein zweites Transistorpaar (MNYSR, MNYSR_), wodurch der Leseverstärker und die lokalen Ein-/Ausgabeleitungen gekoppelt werden, wobei das zweite Signal das Übertragen eines Datensignals vom Leseverstärker zu den lokalen Ein-/Ausgabeleitungen bewirkt, wobei der Schritt des Anlegens eines ersten Signals (YSW) das Anlegen eines Signals beinhaltet, das Steuer- und Adresseninformationen enthält, und wobei der Schritt des Anlegens eines zweiten Signals (YSR) das Anlegen eines Signals beinhaltet, das Steuer- und Adresseninformationen enthält.

6. Verfahren nach Anspruch 5, wobei der Schritt des Anlegens eines ersten Signals den Schritt des Kombinierens eines Schreibfreigabesignals und eines Y-Wählsignals zur Bildung des ersten Signals beinhaltet und
wobei der Schritt des Anlegens eines zweiten Signals den Schritt des Kombinierens eines Lesefreigabesignals und eines Y-Wählsignals zur Bildung des zweiten Signals beinhaltet.

7. Speichereinheit mit:
einem Speicherzellenfeld zum Speichern von Datensignalen,
einem Leseverstärker (12) zum Anlegen von Datensignalen an das Speicherzellenfeld und zum Empfangen von Datensignalen von diesem,
einer Adressen- und Steuereinheit (10) zum Anlegen von Steuersignalen an den Leseverstärker,
einer Ein-/Ausgabepuffereinheit (15),
lokalen Ein-/Ausgabeleitungen (RES_LIO, RES_LIO_) zum Übertragen von Signalen zur Ein-/Ausgabepuffereinheit und
einer Direktleseschaltung, die zwischen die Ein-/Ausgabepuffereinheit und den Leseverstärker geschaltet ist, wobei die Direktleseschaltung ansprechend auf ein Steuersignal von der Adressen- und Steuersignaleinheit ein Datensignal von der Ein-/Ausgabeeinheit zum Leseverstärker sendet und wobei die Direktleseschaltung ansprechend auf ein zweites Steuersignal von der Adressen- und Steuereinheit ein Datensignal vom Leseverstärker zu den lokalen Ein/Ausgabeleitungen sendet, **dadurch gekennzeichnet, daß** das eiste und das zweite Signal (YSW, YSR) Adressen- und Steuerinfomiationen enthalten.

8. Speichereinheit nach Anspruch 7, wobei das erste Steuersignal eine Kombination eines Schreibfreigabesignals und eines Y-Wählsignals ist.

9. Speichereinheit nach Anspruch 7 oder 8, wobei das zweite Steuersignal eine Kombination eines Lesefreigabesignals und des Y-Wählsignals ist.

10. Speichereinheit nach einem der Ansprüche 7 bis 9, wobei das erste und das zweite Signal jeweils ein Komplementsignal beinhalten.

11. Speichereinheit nach einem der Ansprüche 7 bis 10, wobei die Direktleseschaltung aufweist:
ein erstes Transistorpaar, das auf das erste Signal anspricht, um ein Datensignal zu senden, und
ein zweiten Transistorpaar, das auf das zweite Signal anspricht, um ein Datensignal zu senden.

12. Speichereinheit nach einem der Ansprüche 7 bis 11, wobei die Speichereinheit eine dynamische Direktzugriffsspeichereinheit (DRAM-Einheit) ist

## Revendications

1. Amplificateur de détection (12) à utiliser dans une unité de mémoire, ledit amplificateur de détection comprenant :
une paire de lignes d'entrée/sortie locales (RES_LIO, RES_LIO_);
un circuit de détection directe permettant de coupler ledit amplificateur de détection et ladite paire de lignes locales, ledit circuit de détection directe comprenant ;
une première paire de transistors (MNYSW, MNYSW_) réactive à un premier signal et
une seconde paire de transistors (MNYSR, MNYSR_) réactive à un second signal, ledit premier signal déclenchant la transmission d'un signal de données depuis la paire de lignes d'entrée/sortie locales vers ledit amplificateur de détection, ledit second signal déclenchant la transmission d'un signal de données depuis ledit amplificateur de détection vers ladite paire de lignes d'entrée/sortie locales, **caractérisé en ce que** lesdits premier et second signaux (YSW, YSR) contiennent des informations d'adresse et de commande.

2. Amplificateur de détection selon la revendication 1, dans lequel ladite unité de mémoire est une unité de mémoire RAM dynamique.

3. Amplificateur de détection selon la revendication 1 ou la revendication 2, dans lequel ledit premier signal est une combinaison d'un signal WRITE-ENABLE et d'un signal Y-SELECT et ledit second signal est une combinaison d'un signal READ-ENABLE et du dit signal Y-SELECT.

4. Amplificateur de détection selon l'une des revendications précédentes, dans lequel ledit premier signal est appliqué à un premier transistor et à un second transistor de ladite première paire de transistors.

5. Procédé permettant de coupler un amplificateur de détection (12) et une paire de lignes d'entrée/sortie locales (RES_LIO, RES_LIO_) dans une unité de mémoire RAM dynamique, le procédé comprenant les étapes consistant à :
appliquer un premier signal à une première paire de transistors (MNYSW, MNYSW_) couplant ledit amplificateur de détection et lesdites lignes d'entrée/sortie locales, ladite première paire de transistors transférant un signal de données à partir des dites lignes d'entrée/sortie locales vers ledit amplificateur de détection en réponse au dit premier signal ; et
appliquer un second signal à une seconde paire de transistors (MNYSR, MNYSR_) couplant ledit amplificateur de détection et lesdites lignes d'entrée/sortie locales, ledit second signal déclenchant un signal de données à transférer depuis ledit amplificateur de détection vers lesdites lignes d'entrée/sortie locales dans lequel ladite étape consistant à appliquer un premier signal (YSW) comprend l'application d'un signal contenant des informations d'adresse et de commande et dans lequel ladite étape consistant à appliquer un second signal (YSR) comprend l'application d'un signal contenant des informations de commande et d'adresse.

6. Procédé selon la revendication 5, dans lequel ladite étape d'application d'un premier signal comprend une étape consistent à combiner un signal WRTTE-ENABLE et un signal Y-SELECT afin de former ledit premier signal ; et
dans lequel ladite étape d'application d'un second signal comprend une étape consistant à combiner un signal READ-ENABLE et un signal Y-SELECT afin de former ledit second signal.

7. Unité de mémoire comprenant :
une matrice de cellules de stockage permettant de stocker les signaux de données ;
un amplificateur de détection (12) permettant d'appliquer des signaux de données vers et de recevoir des signaux de données depuis ladite matrice de cellules de stockage ;
une unité de commande et d'adresse (10) permettant d'appliquer des signaux de commande au dit amplificateur de détection ;
une unité tampon d'entrée/soitie (12) ;
des lignes d'entrée/sortie locales (RES_LIO, RES_LIO_) permettant de transmettre des signaux depuis et vers ladite unité tampon d'entrée/sortie ; et
un circuit de détection directe couplé entre ladite unité tampon d'entrée/sortie et ledit amplificateur de détection, ledit circuit de détection directe transmettant un signal de données depuis l'unité d'entrée/sortie vers ledit amplificateur de données en réponse à un signal de commande provenant de ladite unité d'adresse et de commande, ledit circuit de détection directe transmettant un signal de données provenant du dit amplificateur de détection vers lesdites lignes d'entrée/sortie locales en réponse à un second signal de commande provenant de l'unité d'adresse et de commande **caractérisé en ce que** lesdits premier et second signaux (YSW, YSR) contiennent des informations d'adresse et de commande.

8. Unité de mémoire selon la revendication 7, dans laquelle ledit premier signal de commande est la combinaison d'un signal write-enable et d'un signal Y-select.

9. Unité de mémoire selon la revendication 7 ou la revendication 8, dans laquelle ledit second signal de commande est la combinaison d'un signal read-enable et d'un signal Y-select.

10. Unité de mémoire selon l'une des revendications 7 à 9, dans laquelle lesdits premier et second signaux comprennent chacun un ensemble de signaux.

11. Unité de mémoire selon l'une des revendications 7 à 10, dans laquelle ledit circuit de détection directe comprend :
une première paire de transistors réactive au dit premier signal pour transmettre un signal de données ; et
une seconde paire de transistors réactive au dit second signal pour transmettre un signal de données.

12. Unité de mémoire selon l'une des revendications 7 à 11, dans laquelle ladite unité de mémoire est une unité de mémoire RAM dynamique.
